# FASCICULE DE BREVET EUROPEEN

(11) **EP 2 591 506 B1**
(45) Date de publication et mention de la délivrance du brevet: **30.05.2018**
(21) Numéro de dépôt: 11728903.3
(22) Date de dépôt: 05.07.2011
(51) Int. Cl.: H01L 21/76, H01L 23/522, H01L 23/525, H01L 21/336

(54) **PROCÉDÉ DE RÉALISATION D'UN DISPOSITIF MICROELECTRONIQUE A NIVEAUX METALLIQUES D'INTERCONNEXION CONNECTES PAR DES VIAS PROGRAMMABLES**
VERFAHREN ZUR HERSTELLUNG EINER MIKROELEKTRONISCHEN VORRICHTUNG MIT ANHAND VON PROGRAMMIERBAREN DURCHKONTAKTIERUNGEN VERBUNDENEN METALLVERBINDUNGSEBENEN
METHOD OF FORMING A MICROELECTRONIC DEVICE HAVING METAL INTERCONNECTION LEVELS CONNECTED BY PROGRAMMABLE VIAS

(30) Priorité: 06.07.2010 FR 1055467
(43) Date de publication de la demande: 15.05.2013
(73) Titulaire: Commissariat à l'Énergie Atomique et aux Énergies Alternatives, 75015 Paris (FR)
(72) Inventeur: ERNST, Thomas, F-38120 Morette (FR); MOREL, Paul-Henry, F-38700 Corenc (FR); MAITREJEAN, Sylvain, 38000 Grenoble (FR)
(74) Mandataire: Ilgart, Jean-Christophe
(86) Numéro de dépôt international: PCT/EP2011/061332
(87) Numéro de publication internationale: WO 2012/004267

(56) Documents cités:
- EP-A1- 1 770 769
- WO-A1-2005/124872
- DE-A1- 10 250 984
- FR-A1- 2 897 204
- US-A- 5 627 395
- US-A- 5 943 574
- US-A1- 2002 001 905
- US-A1- 2006 125 025
- US-A1- 2006 192 231
- US-A1- 2008 119 016

## Description

### DOMAINE TECHNIQUE

La présente invention concerne le domaine des dispositifs microélectroniques et des circuits intégrés, et plus particulièrement celui des niveaux métalliques superposés d'interconnexion dans ces circuits ou dispositifs.

L'invention concerne la mise en oeuvre d'une structure comportant une électrode de grille ayant un agencement amélioré et prévue pour contrôler la conduction d'éléments d'interconnexion verticaux, communément appelés « vias », afin de former des vias programmables reliant électriquement différents niveaux métalliques d'interconnexions.

### ART ANTÉRIEUR

Pour contrôler le passage de courant entre deux blocs ou circuits logiques, il existe des éléments d'interconnexion fusibles, par exemple de type dit « laser » ou « à électro-migration ».

Ces éléments d'interconnexion ont généralement pour inconvénients d'être encombrants, de fonctionner pour des gammes de courant importantes et de ne pas être réutilisables.

En cas de surintensités, de tels éléments n'assurent plus d'interconnexions entre les circuits.

Par ailleurs, pour les éléments d'interconnexion fusibles à électro-migration, un circuit de détection d'erreurs supplémentaire peut être rendu nécessaire.

Dans un autre domaine, celui des réseaux logiques programmables et en particulier des FPGA (« Field Programmable Gate Array » en anglais), des cellules logiques élémentaires peuvent être interconnectées de manière réversible par programmation.

Pour cela, des connexions reprogrammables sont faites à l'aide d'une mémoire flash, reliée à un transistor qui contrôle le passage du courant entre deux blocs.

Ce type d'interconnexion reprogrammable peut être réutilisé un nombre limité de fois, par exemple de l'ordre de 20000 fois, est encombrant, et fonctionne généralement pour des gammes de tensions importantes incompatibles avec les tensions utilisées pour la logique CMOS.

Le document de K. N. Chen, "Programmable via Using Indirectly Heated Phase-Change Switch for Reconfigurable Logic Applications », Electron Device Letters, Vol. 29, No 1, 2008, divulgue un dispositif microélectronique doté de niveaux métalliques d'interconnexion superposés et connectés entre eux par des via dits "programmables" formés d'un matériau à changement de phase, et dont on fait varier la résistance en faisant varier la chaleur appliquée au dit matériau à l'aide d'une ligne conductrice chauffante.

Un tel dispositif pose des problèmes en termes notamment, de rapidité de fonctionnement en mode dynamique, de variabilité dans le temps de la résistance des vias, et de consommation.

Les documents US 5 627 395, US 2008 0119016 A1 divulguent une structure d'interconnexion permettant de connecter entre elles des lignes métalliques sous forme d'un transistor à canal semi-conducteur vertical dont la conduction est modulée au moyen d'une électrode de grille formée autour du canal.

La réalisation d'une telle électrode de grille est complexe dans la mesure où elle nécessite un positionnement et un dimensionnement précis.

Dans le domaine des transistors à canal vertical, le document WO 2005/124872 A1 prévoit un transistor à canal vertical formé d'une pluralité de nano-fils réalisés par croissance sur une couche semi-conductrice.

Il se pose le problème de réaliser une nouvelle structure d'interconnexion à canal semi-conducteur vertical dans lequel la mise en oeuvre de la grille ne présente pas les inconvénients évoqués ci-dessus.

### EXPOSÉ DE L'INVENTION

L'invention concerne un procédé de réalisation d'un dispositif microélectronique selon la revendication 1.

En formant l'électrode de grille, notamment par dépôt de diélectrique de grille et de matériau de grille dans une cavité dans laquelle l'élément semi-conducteur est déjà disposé, on réalise une électrode de grille, sans devoir dimensionner cette électrode de grille au moyen d'une ou plusieurs étapes de gravure.

Selon le procédé de l'invention, la réalisation de l'élément semi-conducteur est obtenue par une croissance directement sur la première ligne métallique, de sorte que l'élément semi-conducteur réalisé est formé en contact avec cette ligne.

Dans ce cas, la croissance de l'élément semi-conducteur peut être, selon une première possibilité, effectuée à l'aide d'un catalyseur déposé sur la première ligne métallique.

La croissance peut être réalisée dans une cavité comportant des flancs latéraux et un fond, le fond dévoilant la première ligne métallique, la croissance de l'élément semi-conducteur pouvant être effectuée à l'aide d'un bloc de catalyseur formé par dépôt sélectif, sans recouvrir les flancs de la cavité.

Selon une deuxième possibilité, la croissance de l'élément semi-conducteur peut être effectuée en se servant du matériau métallique de la première ligne métallique comme catalyseur.

La réalisation de l'élément semi-conducteur peut être mise en oeuvre dans une cavité formée à travers une couche diélectrique et dévoilant la première ligne métallique.

Le procédé peut comporter en outre la formation de la deuxième ligne métallique sur l'élément semi-conducteur, après avoir formé la grille.

Selon une possibilité qui ne fait pas partie de l'invention, la réalisation de l'élément semi-conducteur peut être mise en oeuvre à partir d'une première zone semi-conductrice ou métallique en contact avec la première ligne métallique.

Dans ce cas, ladite cavité dévoile ladite zone semi-conductrice.

Ladite cavité peut également comporter des flancs latéraux dévoilant des régions d'une deuxième zone, semi-conductrice ou métallique, en contact avec la deuxième ligne métallique.

Le procédé selon cette possibilité qui ne fait pas partie de l'invention peut comporter en outre, après avoir formé la cavité et préalablement à la réalisation de l'élément semi-conducteur, une gravure de ladite couche diélectrique de manière à élargir une partie de ladite cavité et dévoiler une face inférieure de ladite deuxième zone en contact avec la deuxième ligne métallique, l'élément semi-conducteur pouvant être réalisé à partir de la première zone en contact avec la première ligne métallique et de manière à atteindre ladite deuxième zone en contact avec la deuxième ligne métallique.

Selon le procédé de l'invention, l'élément semi-conducteur est formé d'une pluralité de nano-fils.

Selon une possibilité de mise en oeuvre de ladite variante de réalisation qui ne fait pas partie de l'invention, le procédé peut comprendre des étapes consistant à :
- faire croître l'élément semi-conducteur sous forme de plusieurs nano-fils sur la zone semi-conductrice,
- former la couche diélectrique, de manière à entourer les nano-fils,
- dévoiler au moins une extrémité de chaque nanofil semi-conducteur,
le procédé pouvant comprendre en outre la réalisation d'une autre zone semi-conductrice en contact avec les nanofils et de la deuxième ligne métallique sur ladite autre zone semi-conductrice.

L'étape consistant à dévoiler au moins une extrémité de chaque nano-fil semi-conducteur peut être réalisée par polissage.

Le procédé peut alors comprendre en outre :
- la formation de la cavité autour des nano-fils et dévoilant ces derniers,
- la formation de la grille dans la cavité.

Le procédé peut comprendre en outre une ou plusieurs étapes de dopage lors de la réalisation de l'élément semi-conducteur, de sorte que l'élément semi-conducteur comporte au moins deux zones superposées de dopage différent, ou soit dopé selon un seul type de dopage uniforme ou non.

Selon une variante qui ne fait pas partie de l'invention, la réalisation de l'élément de connexion semi-conducteur peut comporter le dépôt d'au moins une couche de semi-conducteur dans la cavité. La présente demande concerne également un dispositif microélectronique comprenant :
- un substrat et une pluralité de niveaux métalliques d'interconnexions superposés sur le substrat,
- une première ligne métallique d'un niveau métallique d'interconnexion donné,
- une deuxième ligne métallique d'un autre niveau métallique d'interconnexion situé au-dessus dudit niveau métallique d'interconnexion donné, lesdites première et deuxième lignes étant connectées entre elles par l'intermédiaire d'au moins un élément de connexion semi-conducteur s'étendant dans une direction réalisant un angle non-nul avec lesdites première ligne métallique et deuxième ligne métallique, le dispositif comprenant en outre une électrode de grille pour contrôler la conduction dudit élément de connexion semi-conducteur. L'électrode de grille et l'élément semi-conducteur peuvent être agencés de sorte qu'au moins une région d'électrode de grille est entourée par l'élément semi-conducteur.

Ainsi, un contrôle du courant traversant le via semi-conducteur est mis en oeuvre à l'aide d'au moins une région de l'électrode de grille étant entourée par l'élément semi-conducteur.

Le dispositif met en oeuvre un ou plusieurs vias programmables semi-conducteurs, éventuellement en matériau semi-conducteur monocristallin, pour permettre à ce ou ces vias de jouer le rôle de canal ou canaux d'un transistor.

Selon une possibilité de mise en oeuvre, l'élément semi-conducteur peut être formé de plusieurs nano-fils disposés autour de ladite région d'électrode de grille.

Par « nanofil », on entend un barreau de dimension critique comprise entre environ 5 nm et 500 nm de diamètre.

Selon une autre possibilité de mise en oeuvre, l'élément semi-conducteur peut être formé d'une couche semi-conductrice entourant l'électrode de grille.

La première ligne métallique et la deuxième ligne métallique peuvent être situées respectivement dans un premier plan et un deuxième plan parallèle au premier plan. Ladite région de l'électrode de grille entourée par l'élément semi-conducteur peut être reliée à une portion de matériau électriquement conducteur sous forme d'une ligne située dans un plan parallèle au premier plan et au deuxième plan.

Cette portion de matériau électriquement conducteur peut permettre une prise de contact aisée sur la grille.

La première ligne métallique et la deuxième ligne métallique peuvent s'étendre dans des directions différentes, ladite portion de matériau électriquement conducteur sous forme d'une ligne pouvant s'étendre dans une autre direction, différente de celles dans lesquelles la première ligne métallique et la deuxième ligne métallique s'étendent respectivement. Un tel agencement permet de limiter les effets capacitifs dans le dispositif.

L'électrode de grille peut être reliée à une portion de matériau électriquement conducteur sous forme d'une ligne métallique d'un niveau métallique d'interconnexion autre que les niveaux métalliques d'interconnexion de la première ligne métallique et de la deuxième ligne métallique.

Selon une possibilité de mise en oeuvre, l'élément semi-conducteur peut être en contact direct avec la première ligne métallique et/ou la deuxième ligne métallique.

Selon une variante, l'élément semi-conducteur peut être en contact avec une première zone, semi-conductrice ou métallique, elle-même en contact avec la première ligne métallique et/ou être en contact avec une deuxième zone, semi-conductrice ou métallique, elle-même en contact avec la deuxième ligne métallique.

Un tel dispositif peut, selon un exemple d'application, être mis en oeuvre dans un circuit reconfigurable de type FPGA, afin de reconfigurer les connexions entre des blocs logiques de base.

Dans une architecture 3D (trois dimensions) comprenant par exemple, sur une même puce, des blocs de fonctions logiques et/ou des blocs de type mémoire et/ou des blocs de communication optique et/ou des blocs de type capteur, de tels vias programmables peuvent servir d'éléments de réparation des erreurs pour les blocs de type mémoire, d'éléments de cryptage de données ou encore effectuer des fonctions logiques programmables.

De plus, dans une architecture 3D, de tels vias programmables peuvent être intégrés sur un ou plusieurs niveaux.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un premier exemple de dispositif microélectronique doté d'un via semi-conducteur programmable dont la conduction est contrôlée par un transistor ayant une structure verticale,
- les figures 2A-2R illustrent un exemple de procédé de réalisation d'un dispositif microélectronique doté d'un via semi-conducteur dont la conduction est contrôlée par un transistor,
- les figures 3A-3B illustrent une variante de réalisation d'un via semi-conducteur, par croissance sur une ligne métallique sans apport de catalyseur,
- les figures 4A et 4B illustrent un exemple de dispositif microélectronique doté d'un via semi-conducteur programmable sous forme d'une pluralité de nano-fils dont la conduction est contrôlée par un transistor ayant une structure verticale,
- les figures 5A-5C illustrent un exemple de procédé de réalisation d'un dispositif microélectronique doté d'un via semi-conducteur programmable réalisé par croissance, à partir d'une zone semi-conductrice, de nano-fils dont la conduction est destinée à être contrôlée par une électrode de grille,
- les figures 6A-6C illustrent une variante de procédé,
- les figures 7A-7C illustrent une autre variante de procédé suivant l'invention,
- les figures 8A-8C illustrent un autre exemple de procédé suivant l'invention,
- les figures 9A-9D et 10 illustrent un autre exemple de procédé suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

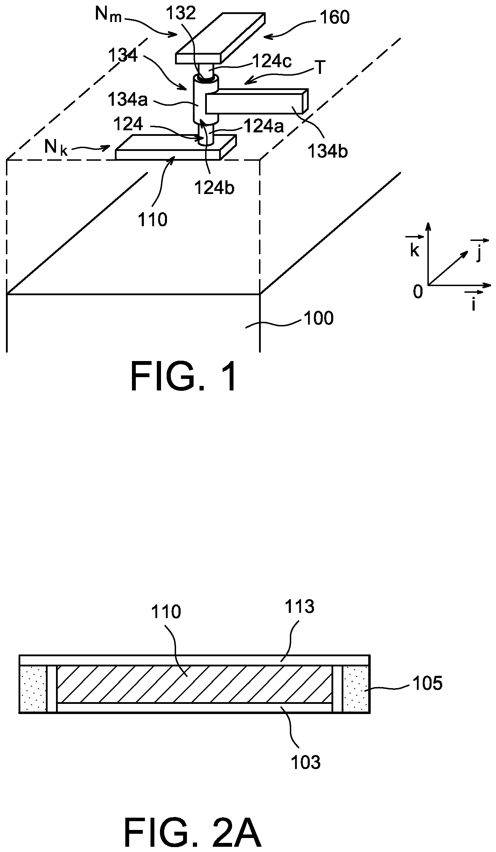

Un exemple de dispositif microélectronique doté d'un élément d'interconnexion vertical communément appelés « via » semi-conducteur commandé est donné sur la figure 1.

Ce dispositif est formé sur un substrat 100 sur lequel une pluralité de composants (non représentés) et de niveaux métalliques N₁,...,Nₚ superposés d'interconnexion des composants ont été réalisés.

Chaque niveau métallique d'interconnexion comporte une ou plusieurs lignes métalliques horizontales, par exemple à base de cuivre.

Une ligne métallique horizontale d'un niveau métallique est connectée à une autre ligne métallique horizontale d'un niveau supérieur et/ou inférieur par l'intermédiaire d'un ou plusieurs éléments de connexion verticaux communément appelés vias.

On entend par « horizontale » une direction parallèle au plan principal du substrat 100 c'est-à-dire un plan passant par le substrat et parallèle au plan [O*;i̅;j̅*] d'un repère orthogonal [O*;i̅;j̅;k̅*] donné sur la figure 1.

On entend par « verticale » une direction réalisant un angle non-nul avec le plan principal du substrat 100, sur lequel le dispositif est formé, c'est-à-dire une direction réalisant un angle non-nul avec le plan [O*;i̅;j̅*] du repère orthogonal [O;*i̅;j̅;k̅*] donné sur la figure 1.

Ce dispositif comprend notamment une première ligne métallique horizontale 110 d'un niveau métallique donné Nₖ (avec k un entier non nul inférieur à un entier p) connectée, par l'intermédiaire d'un élément de connexion vertical 124, à une ligne métallique horizontale 160 d'un niveau métallique Nₘ supérieur (avec k < m ≤ p).

Cet élément de connexion vertical 124, est sous forme d'un barreau ou d'un nano-fil, à base de matériau semi-conducteur, par exemple à base de Si.

Une zone 124b de l'élément de connexion vertical 124 est entourée d'une zone 131 de diélectrique de grille, par exemple à base de HfO₂ ou d'Al₂O₃, cette zone 131 de diélectrique étant elle-même recouverte d'une portion 134a d'une grille, ou électrode de grille, 134 enrobante, entourant l'élément 124.

La grille 134 peut également comporter une autre portion 134b, qui est jointe à la portion 134a enrobante, et qui s'étend dans la direction horizontale.

La grille 134 permet, en fonction du potentiel qui lui est appliqué, de contrôler la circulation de courant entre les lignes métalliques 110 et 160 en contrôlant la conduction de l'élément 124.

Des zones 124a et 124c de l'élément de connexion 124 semi-conducteur, situées de part et d'autre de la zone 124b, jouent respectivement le rôle de zone de source et de drain d'un transistor T, tandis que la zone 124b forme un canal de ce transistor dont la conduction est contrôlée par la grille 134.

Le transistor T permet, suivant la manière dont la grille 134 est polarisée, de moduler un courant transitant entre les lignes métalliques 110 et 160.

Le transistor T peut être prévu pour jouer le rôle d'interrupteur commandé afin de laisser passer ou non du courant entre les lignes métalliques 110 et 160.

Le transistor T peut être également prévu pour jouer le rôle d'amplificateur de courant entre les lignes métalliques 110 et 160.

Le transistor à structure verticale ainsi formé entre les lignes métalliques 110 et 160 peut avoir un fonctionnement du type de celui d'un transistor MOS.

Selon une variante, la position du drain et de la source peut être inversée.

Selon une mise en oeuvre particulière de ce dispositif, les lignes métalliques 110, 160 et la portion horizontale 134b de grille peuvent être disposées de sorte qu'elles s'étendent dans trois directions différentes.

Un tel agencement peut permettre de minimiser les effets capacitifs entre ces trois éléments 110, 160 et 134b.

Un premier exemple de procédé de réalisation d'un dispositif microélectronique du type de celui décrit précédemment en liaison avec la figure 1, va à présent être donné en liaison avec les figures 2A-2R.

Sur la figure 2A, une ligne métallique 110 horizontale d'un niveau métallique d'interconnexion appartenant à un dispositif en cours de réalisation est représenté. Le dispositif comprend un substrat (non représenté) sur lequel des composants ont été formés, par exemple des transistors, ou des composants d'un circuit logique (les composants n'étant pas représentés).

Cette ligne métallique 110 peut avoir été réalisée dans une couche diélectrique 105, par exemple à base de SiO₂. De plus, dans l'exemple décrit ici, une couche barrière 103, par exemple à base de CoWP ou de TiN ou de TaN est disposée entre la ligne métallique 110 et la couche diélectrique 105.

La ligne métallique 110 est recouverte d'une couche 113 d'encapsulation isolante, par exemple à base de nitrure de silicium ou de carbure de silicium, prévue pour protéger cette dernière, et qui pourra servir de couche d'arrêt de gravure (figure 2A).

On dépose ensuite une couche diélectrique 115, par exemple à base de SiO₂. La couche diélectrique 115 peut être déposée par exemple par voie physique à partir d'un précurseur gazeux par exemple de type SiH₄, ou d'un précurseur liquide par exemple de type Tetra Ethyle Ortho Silane. L'épaisseur de la couche diélectrique 115 correspond à la distance séparant deux niveaux métalliques d'interconnexion et à la hauteur prévue pour un ou plusieurs éléments verticaux d'interconnexion, communément appelés via destinés à connecter ces niveaux. La couche diélectrique 115 peut avoir par exemple une épaisseur comprise entre environ 30 nm et 1500 nm.

Une cavité 119 est ensuite formée dans la couche diélectrique 115.

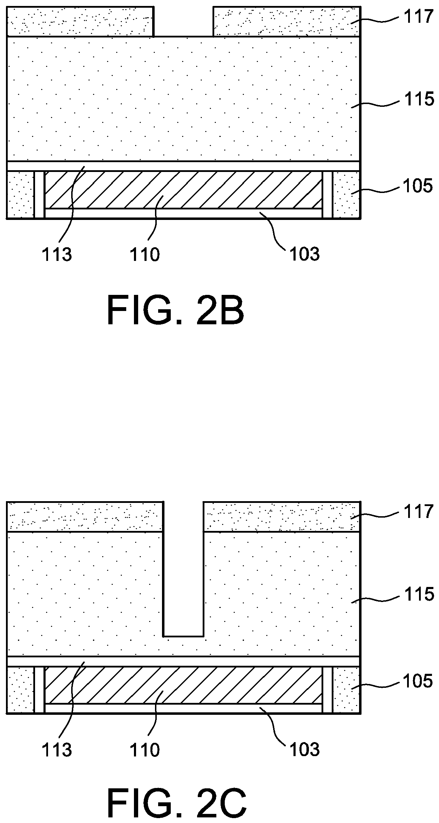

Pour cela, on réalise tout d'abord un masquage 117, formant un masque dur par exemple à base de résine, sur la couche diélectrique 115 (figure 2B).

Une étape de gravure physique, par exemple de type RIE (RIE pour « Reactive Ion Etching ») avec arrêt sur la couche de protection 113 peut être réalisée afin de transférer le motif du masquage 117 dans la couche diélectrique 115.

Une variante consiste à réaliser une première gravure de manière à former un trou dont le fond se situe dans la couche diélectrique 115, sans atteindre la couche d'encapsulation 113 (figure 2C). Cela permet de ne pas détériorer la face supérieure de la couche d'encapsulation 113 lorsque la gravure est une gravure sèche.

Pour cette variante, la première gravure est alors suivie d'une deuxième gravure, afin d'élargir le trou et d'atteindre la couche d'encapsulation 113. Cette deuxième gravure peut être par exemple une gravure humide à base de HF lorsque la couche diélectrique 115 est à base d'oxyde de silicium.

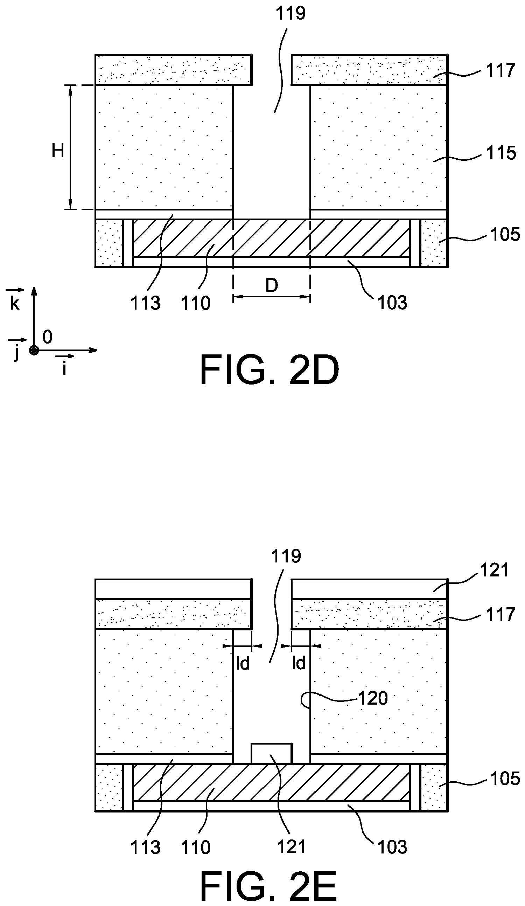

On peut ensuite procéder à une gravure de la couche 113 d'encapsulation, de manière à dévoiler la ligne métallique d'interconnexion 110 (figure 2D).

Pour réaliser une cavité 119 présentant un facteur de forme (diamètre D/hauteur H) important, par exemple au moins égal à 4, une étape préalable de traitement à l'aide d'un plasma O₂, peut permettre de rendre les flancs des motifs du masquage 117 hydrophiles. Cela peut être suivi d'une étape de prémouillage dans de l'eau dé-ionisée.

Une cavité 119 de dimension critique ou de diamètre D (mesurée dans la direction parallèle au plan [O*;i̅;j̅*] d'un repère orthogonal [O*;i̅;j̅;k̅*] indiqué sur la figure 2D) compris par exemple entre 150 nanomètres et 200 nanomètres peut être ainsi réalisée.

La cavité 119 peut avoir une hauteur H (mesurée dans la direction parallèle au vecteur *̅k̅*̅ du repère orthogonal [O*;i̅;j̅;k̅*]) comprise par exemple entre environ 30 nanomètres et 1500 nanomètres.

Une étape de retrait du masquage 117 de la résine communément appelé « stripping » et de nettoyage par exemple à base de HF pour enlever des résidus, notamment des résidus de polymère(s) qui peuvent avoir été formés lors des précédentes étapes de gravure, peut être éventuellement effectuée.

Un tel nettoyage de la surface de la ligne métallique 110 peut être utile à la préparation du dépôt ultérieur d'un catalyseur.

Ensuite, on effectue une étape de dépôt de ce catalyseur 121 au fond de la cavité 119. Le catalyseur 121 de croissance peut être par exemple du cuivre, ou de l'aluminium, ou de l'indium, ou du nickel. L'épaisseur de ce catalyseur 121 est adaptée en fonction des caractéristiques du ou des nanofils destinés à être réalisés à partir de ce catalyseur 121 pour former le via. Par exemple, lorsque le catalyseur 121 est à base d'or et que l'on souhaite réaliser un seul nanofil remplissant la totalité du volume de la cavité 119, et lorsque le diamètre D de la cavité 119 est égal à environ 50 nm, le catalyseur 121 peut avoir une épaisseur (dimension parallèle à l'axe k) supérieure ou égale à environ 25 nm.

Le catalyseur 121 est déposé au fond de la cavité 119, de préférence sans que les parois 120 de la cavité 119, correspondant à des flancs de la couche diélectrique 115, soient recouvertes. Pour cela, on peut, selon une première possibilité, réaliser un dépôt de catalyseur sur la ligne métallique 110 sélectif vis-à-vis de la couche diélectrique 115.

Ce dépôt sélectif peut être par exemple un dépôt électrochimique dans le cas où une prise de contact sur la ligne métallique est prévue, ou encore par un dépôt sélectif par voie electroless (chimique) ne nécessitant pas de prise de contact sur la ligne métallique.

L'état de surface de la ligne métallique 110 revêtant une importance particulière pour la réussite du dépôt du catalyseur, un prétraitement de la ligne métallique 110 peut être éventuellement effectué, afin d'enlever ce qui pourrait empêcher le dépôt électrochimique du catalyseur. Par exemple, pour une ligne métallique de cuivre, un prétraitement à l'acide sulfurique peut être effectué afin d'enlever d'éventuels zones de cuivre oxydées.

Selon une variante, un dépôt non sélectif du catalyseur, par exemple un dépôt physique par évaporation peut être effectué.

Dans ce cas, afin de protéger les parois 120 de la cavité 119 lors du dépôt du catalyseur, on prévoit un masquage, qui peut être le masquage 117 dans le cas où ce dernier a été conservé, ou un autre masquage, que l'on forme préalablement au dépôt.

Dans les deux cas, le masquage peut avoir été réalisé de sorte que des portions de ce dernier dépassent au dessus de la cavité 119 et viennent surplomber cette dernière (figure 2E).

La longueur l_{d} (mesurée dans une direction parallèle au plan [O*;i̅;j̅*] du repère orthogonal [O*;i̅;j̅;k̅*]) de dépassement du masquage 117 au dessus de la cavité 119 est prévue en fonction de la hauteur H de la cavité 119, et peut être prévue de sorte que l_{d} ≥ (1/10)*H, par exemple de l'ordre de 50 nm pour une cavité de 500 nm de hauteur.

Dans le cas où le masquage 117 a été conservé, le surplomb peut avoir été réalisé lors de ladite deuxième étape de gravure effectuée pour réaliser la cavité 119, et qui a été décrite précédemment en liaison avec la figure 2D.

Dans le cas où la première étape de gravure de la couche diélectrique 115 décrite précédemment avec la figure 2C a permis de former une ouverture de 150 nm de diamètre et de manière à laisser 30 nm de la couche diélectrique 115 au fond, suivie d'une deuxième étape de gravure humide, on peut avoir obtenu une cavité 119 de 250 nm de diamètre D avec des parois protégés par un masquage de résine 117 dépassant d'une longueur de dépassement ld de l'ordre de 50 nm.

Une autre variante consiste à réaliser la cavité 119 et le dépôt de catalyseur, à travers un masquage 117 sous forme de masque dur métallique, par exemple à base de TiN.

Dans ce cas, le masquage peut être prévu avec une épaisseur au moins être égale au dixième de l'épaisseur de la couche diélectrique 115 afin de ne pas être totalement consommé lors de la réalisation de la cavité dans la couche diélectrique 115.

Ensuite, après avoir déposé le catalyseur 121, on retire les portions de ce catalyseur 121 sur le masquage 117 tout en conservant un bloc 121b de catalyseur au fond de la cavité 119.

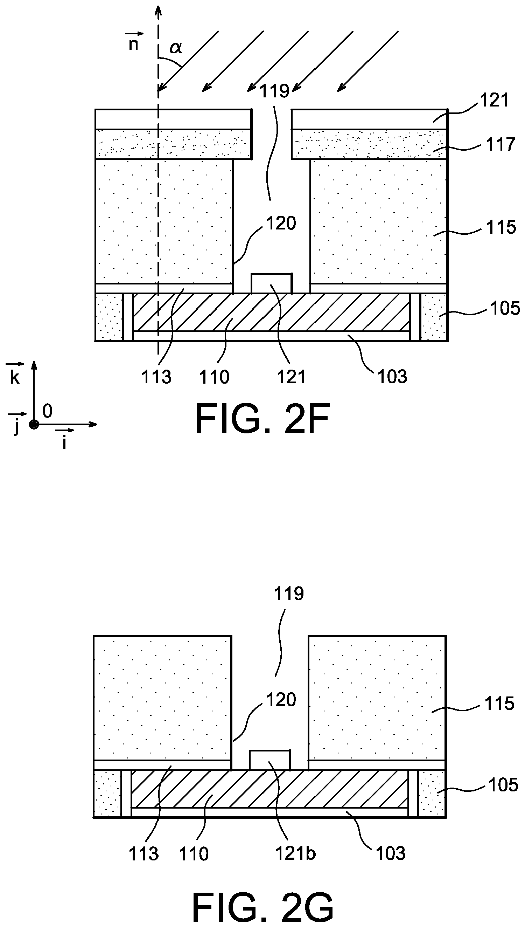

Ce retrait sélectif peut être effectué à l'aide d'une gravure ionique, par exemple par IBE (IBE pour « Ion Beam Etching ») à l'aide d'un faisceau incliné réalisant un angle α non-nul par rapport à une normale *̅n̅*̅ au plan principal de la couche diélectrique 115 (le plan principal de la couche diélectrique 115 étant défini par un plan passant par cette couche et parallèle au plan [O;*̅i̅*̅;*̅j̅*̅] d'un repère orthogonal [O*;i̅;j̅;k̅*] sur la figure 2F).

Pour une cavité 119 ayant un facteur de forme (profondeur/diamètre) au moins égal à 1, un angle α d'au moins 45° peut être prévu.

Ceci permet de réaliser un retrait efficace du catalyseur 121 présent sur le masquage 117 et d'éviter de retirer le catalyseur 121 présent en fond de la cavité 119.

Le masquage peut ensuite être enlevé, par exemple à l'aide d'un solvant et/ou d'un plasma (figure 2G).

Ensuite, une croissance d'un élément semi-conducteur 124 est réalisée dans la cavité 119, à l'aide du bloc 121b de catalyseur 121. L'élément semi-conducteur 124 peut être sous forme d'un barreau ou d'un nano-fil.

Cette croissance peut être effectuée dans un bâti de CVD (CVD pour « Chemical Vapour Deposition ») et peut se dérouler en deux ou trois étapes.

Tout d'abord, un recuit sous atmosphère inerte est réalisé. Selon le catalyseur utilisé, une étape de prétraitement du catalyseur peut être mise en oeuvre, comme par exemple un traitement aux radicaux hydrogène lorsque le catalyseur est à base d'aluminium ou d'indium, ou une oxydation lorsque le catalyseur est à base de cuivre. Puis on effectue une croissance sous une atmosphère contenant un gaz précurseur du matériau semi-conducteur que l'on souhaite faire croitre, par exemple du SiH₄, du SiCl₂ ou du SiCl₄ dans le cas où l'on souhaite faire croitre du Si.

La température à laquelle la croissance est effectuée peut être choisie en fonction du catalyseur et du gaz précurseur utilisés.

La température de croissance peut être par exemple prévue entre environ 350°C et 450°C, en particulier dans le cas où le catalyseur est à base d'aluminium et que le précurseur est du SiH₄. Une telle gamme de températures permet de ne pas dégrader les lignes métalliques dans l'environnement du via programmable.

Un plasma peut être éventuellement utilisé pendant la croissance. Cela permet de compenser les limitations en température imposées par la croissance sur du métal.

Pour une croissance à l'aide d'un précurseur à base de SiH₄, du HCl peut être ajouté au mélange gazeux afin d'éviter la diffusion du catalyseur sur les flancs du nanofil pendant sa croissance et limiter le dépôt non désiré de silicium non catalysé autour du nanofil en croissance.

Il est possible de doper l'élément semi-conducteur 124 et de lui conférer un profil de dopage particulier lorsqu'on le fait croitre, en réalisant un dopage *in-situ* pendant la croissance.

Les paramètres de dopage peuvent être tels que ceux utilisés par exemple dans le document : « Vertically aligned Si intrananowire p-n diodes by large-area epitaxial growth », de Cheol-Joo Kim, Donghun Lee, Hyun-Seung Lee, Geunhee Lee, Gil-Sung Kim, et Moon-Ho Jo, Applied Physics Letters, 94, 2009.

L'élément semi-conducteur 124 peut être réalisé par exemple avec une première zone 124a, surmontée d'une deuxième zone 124b ayant un dopage différent de celui de la première zone 124a, la deuxième zone 124b étant elle même surmontée d'une troisième zone 124c ayant un dopage différent de celui de la deuxième zone 124b.

Différents profils de dopage peuvent être réalisés.

Un profil de dopage pour lequel, par exemple, la zone semi-conductrice comporte une première zone 124a dopée P surmontée d'une deuxième zone 124b dopée N, elle-même surmontée d'une troisième zone dopée P, peut être réalisé.

Selon d'autres possibilités, un profil N-P-N, ou un profil N-I-P (où I désigne une portion intrinsèque c'est-à-dire une zone non dopée), peuvent être mis en oeuvre. Selon une autre possibilité, il est également possible que l'ensemble de l'élément semi-conducteur soit dopé selon un même type de dopage, uniforme ou non. Dans ce cas, l'élément de semi-conducteur 124 forme la zone active d'un transistor MOS à déplétion.

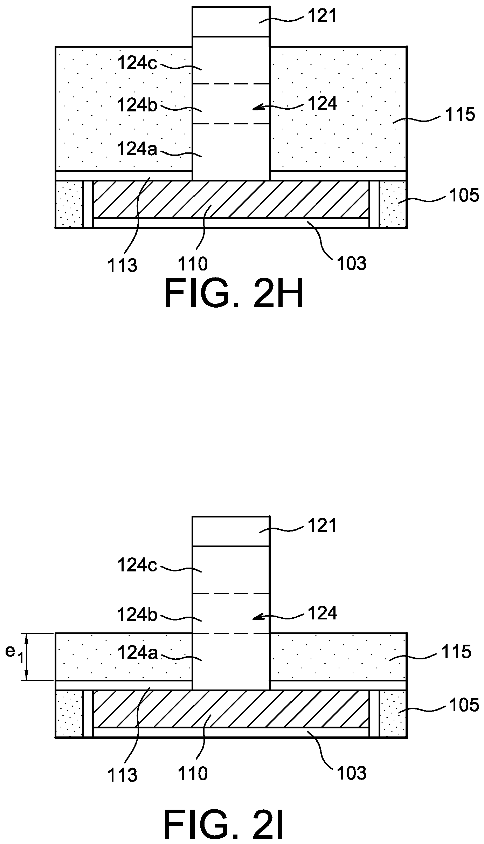

L'élément semi-conducteur 124 est guidé lors de sa croissance par la cavité 119 qui, dans cet exemple, lui impose son diamètre, et sa direction orthogonale à la ligne métallique 110 sur laquelle elle croit. La hauteur de l'élément semi-conducteur 124 est déterminée par la durée de croissance à une vitesse de croissance donnée (figure 2H).

L'élément semi-conducteur 124 peut avoir une hauteur par exemple comprise entre 30 nm et 1500 nm. La durée de croissance est prévue de sorte que l'élément semi-conducteur 124 atteigne au moins l'embouchure de la cavité 119 au niveau de la face supérieure de la couche diélectrique 115.

Après cette étape de croissance, une épaisseur de la couche diélectrique 115 dans laquelle la cavité 119 est formée et ayant servi au guidage de la croissance est retirée. Ce retrait partiel est effectué de manière à conserver une épaisseur e₁ de cette couche diélectrique 115 autour de la zone semi-conductrice 124 (figure 2I).

Le retrait partiel peut être réalisé par gravure, par exemple par une solution tamponnée d'attaque chimique BOE (BOE pour « Buffered Oxide Etchant ») contenant du fluorure d'ammonium et de l'acide fluorhydrique pour graver de l'oxyde de silicium.

Le retrait partiel de la couche diélectrique 115 peut être réalisé de sorte que la face supérieure de l'épaisseur restante de la couche diélectrique 115 est située à la même hauteur, ou sensiblement à la même hauteur que l'interface entre la première zone 124a et la deuxième zone 124b de l'élément semi-conducteur 124.

La zone 124a de l'élément semi-conducteur 124 peut être destinée à former une région de source d'un transistor. Ainsi, l'étape de retrait partiel de la couche diélectrique 115 peut être réalisée de manière à conserver une épaisseur e₁ correspondant à l'épaisseur prévue pour la zone de source d'un transistor (figure 2I).

Après gravure de la couche diélectrique 115, une étape de retrait des résidus du catalyseur est effectuée. Lorsque le catalyseur est de l'or ce retrait peut être effectué à l'aide d'un bain d'eau régale, ou d'une solution à base d'halogénures d'un cation par exemple une solution de KBr, ou de KI. On enlève ainsi le catalyseur métallique 121 au sommet de l'élément semi-conducteur 124 afin d'éviter toute contamination du dispositif et des équipements dans lesquels ce dispositif est destiné à être placé lors de sa fabrication.

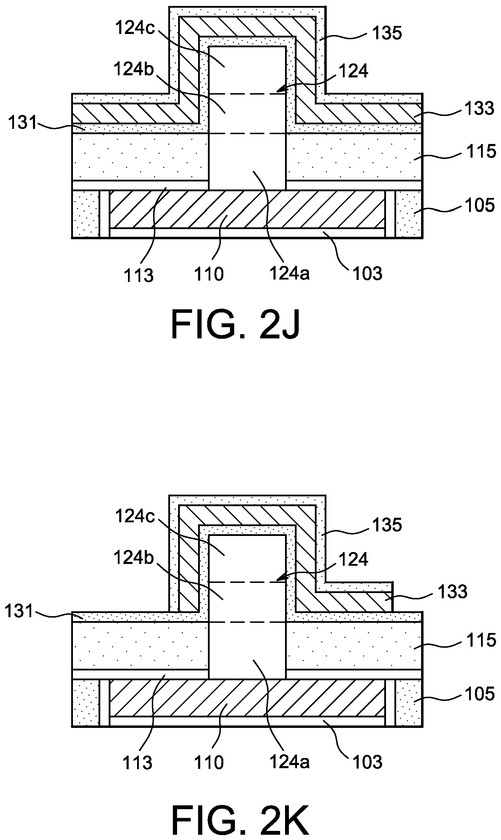

Un empilement de couches 131, 133, 135 est ensuite formé sur la zone semi-conductrice 124 et sur la couche diélectrique 115 (figure 2J).

Pour cela, un dépôt de matériau diélectrique 131 de grille est tout d'abord effectué. Le dépôt peut être réalisé dans un bâti d'ALCVD (ALCVD pour « Atomic Layer Chemical Vapour Déposition ») afin de déposer un diélectrique 131 de type communément appelé « high-k » comme, par exemple, du HfO₂, ou du Al₂O₃, selon une épaisseur par exemple de l'ordre de 3 nanomètres. Un tel dépôt peut être réalisé à une température comprise par exemple entre environ 80°C et 425°C. Afin d'améliorer les qualités d'isolation électrique du matériau diélectrique 131, on réalise de préférence ce dépôt à une température comprise entre environ 370°C et 400°C, facilitant ainsi l'exo-diffusion des intermédiaires réactionnels dans le cas d'un dépôt réalisé par ALCVD.

Puis, un dépôt de matériau 133 de grille, est effectué. Le matériau 133 de grille peut être un matériau métallique. Le matériau de grille peut être par exemple du TiN ou de l'aluminium ou du chrome. Lorsque ce matériau de grille 133 est du TiN, celui-ci est de préférence déposé par CVD, selon une épaisseur par exemple de l'ordre de 50 nm. Un tel dépôt peut être réalisé à une température comprise, par exemple, entre environ 25°C et 400°C. Afin d'obtenir un dépôt bien conforme du matériau 133 de grille, lorsqu'il s'agit de TiN, celui-ci peut être déposé à partir d'un précurseur de type TDMAT (Tetrakis Dimethylamino Titanium) à une température comprise entre environ 350°C et 400°C, à une pression comprise entre environ 4 et 6 torrs et sous une atmosphère contenant par exemple les gaz He, N₂ et H₂.

Sur ce matériau 133 de grille, une couche 135 d'arrêt de gravure, par exemple à base de nitrure de silicium, est ensuite formée. Cette couche 135 d'arrêt de gravure est prévue avec une épaisseur suffisante pour assurer ultérieurement le rôle de tampon lors de gravures destinées à être effectuées pour réaliser des prises de contacts, en particulier de prises de contact vers la grille et au niveau de la partie inférieure de l'élément semi-conducteur 124.

Ensuite, on retire, par exemple par photolithographie et gravure, sur la couche diélectrique 115 des portions de la couche 135 d'arrêt de gravure et de la couche de matériau 133 de grille (figure 2K).

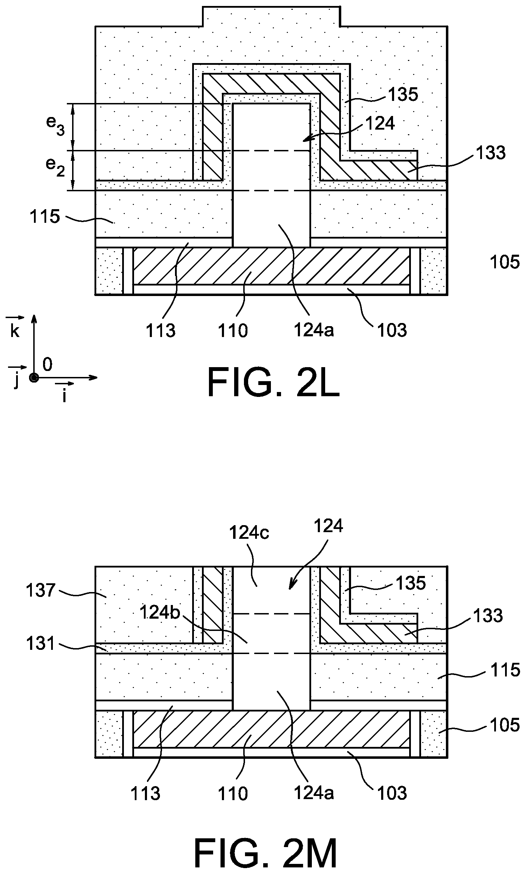

Un dépôt d'une couche diélectrique 137, par exemple à base de SiO₂, est ensuite réalisé de manière à recouvrir l'empilement de couches 131, 133, 135 (figure 2L).

L'épaisseur de la couche diélectrique 137 peut être prévue avec une épaisseur supérieure à l'épaisseur cumulée e₂+e₃ des zones 124b et 124c de l'élément semi-conducteur 124, et qui sont destinées respectivement à former une zone de canal et une zone de drain du transistor. La couche diélectrique 137 peut être par exemple de l'ordre de 50 nm à 100 nm plus épaisse que la longueur cumulée e₂+e₃ de la zone de canal et de la zone de drain du transistor.

Cette étape de dépôt peut être suivie d'une étape consistant à aplanir la couche diélectrique 137 par polissage mécano-chimique, puis à retirer l'empilement constitué du diélectrique 131 de grille, de matériau 133 de grille, et de la couche 135 située au-dessus de la zone semi-conductrice 124. Les parties de l'empilement situées autour de la zone semi-conductrice 124 sont quant à elles conservées (figure 2M).

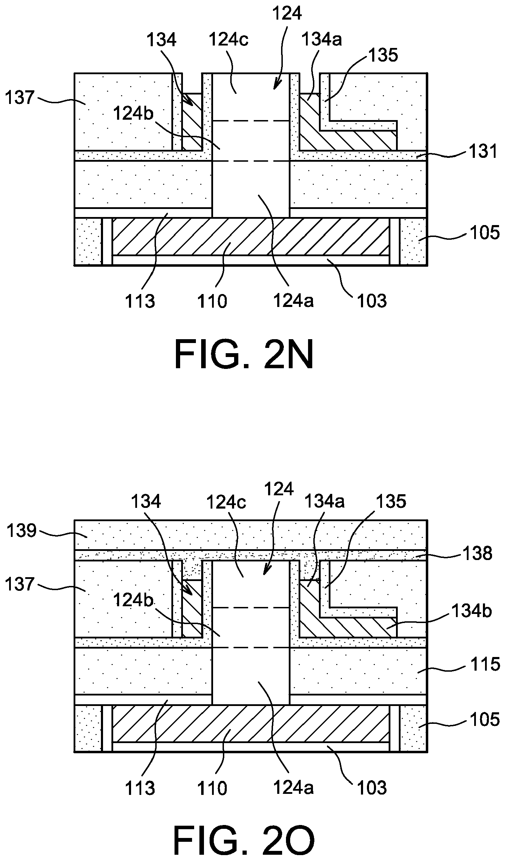

On effectue ensuite un retrait sélectif d'une portion de matériau 133 de grille, de manière à achever la réalisation du motif de grille 134 et prévoir une isolation entre cette grille 134 et un contact supérieur destiné à être formé ultérieurement (figure 2N).

La grille 134 ainsi réalisée comporte une portion 134a enrobant la zone semi-conductrice 124b, et une autre portion 134b, jointe à la portion 134a enrobante, et qui s'étend sur la couche diélectrique 115 dans une direction horizontale.

Dans le cas, par exemple, où le matériau 133 de grille est à base de TiN, une solution chimique à base de 1 volume de NH₄OH pour 2 volumes H₂O et 2 volumes H₂O₂ peut être utilisée pour réaliser ce retrait sélectif.

Ensuite (figure 2O), un dépôt conforme, formant une couche 138 d'arrêt de gravure par exemple à base de nitrure de silicium, est avantageusement mis en oeuvre pour recouvrir l'ensemble des éléments précédemment réalisés qui forment la surface supérieure de l'ensemble représenté sur la figure 2N, à savoir le nano-fil de semi-conducteur 124, la couche diélectrique 137, des portions du diélectrique de grille 131 et de la couche d'arrêt de gravure 135, et remplir les espaces vides obtenus lors de la précédente gravure du matériau de grille 133. L'épaisseur de la couche conforme 138 est de préférence supérieure ou égale à environ 30 nm lorsque l'on souhaite réaliser une ligne métallique supérieure ou niveau Nm d'épaisseur au moins égale à environ 300 nm. Cette couche conforme 138, qui permet de ne pas détériorer le sommet du nanofil de semi-conducteur 124 sur lequel sera pris le contact électrique, est ensuite recouverte d'une couche diélectrique 139, par exemple à base d'oxyde tel que du SiO₂. Ce dépôt peut être suivi d'une étape de polissage mécano-chimique CMP afin de rendre plane la surface de la couche diélectrique 139, et aborder ainsi une étape suivante de photolithographie dans des conditions optimales. L'épaisseur initiale de la couche diélectrique 139 est choisie telle qu'après la mise en oeuvre de la CMP, l'épaisseur restante de la couche diélectrique 139 soit au moins égale à l'épaisseur de la ligne métallique supérieure destinée à être réalisée par la suite.

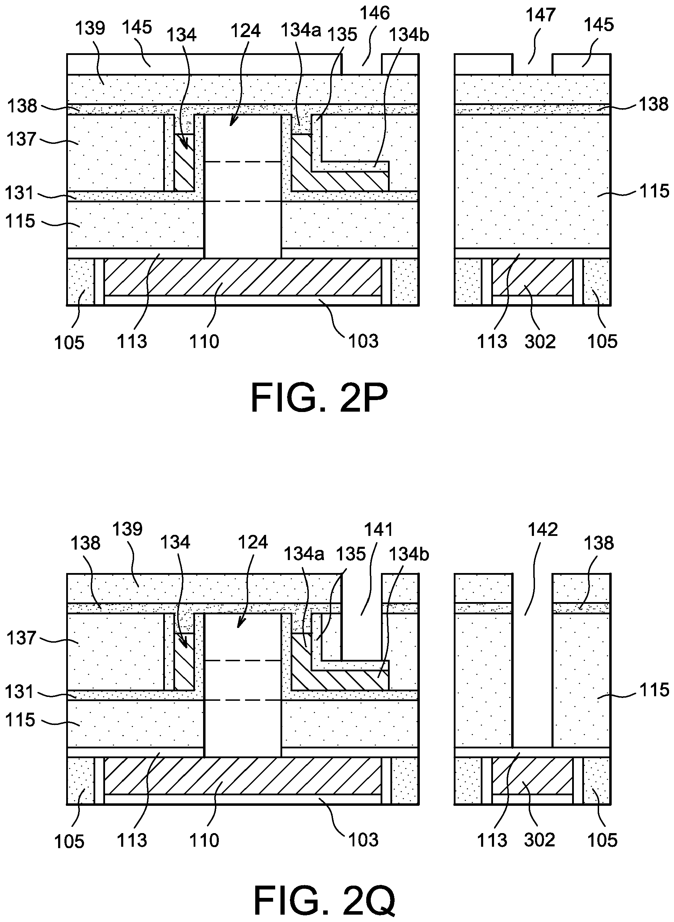

On réalise ensuite les vias électriquement conducteurs destinés à être réalisés dans la couche diélectrique 137. Dans l'exemple décrit ici, un tel via destiné à venir contacter la portion de grille 134b va être réalisé. D'autres vias destinés à venir contacter des portions métalliques du dispositif se situant au même niveau que la ligne métallique 110 peuvent également être réalisés par la mise en oeuvre de mêmes étapes. Ainsi, sur la figure 2P, une portion métallique 302 appartenant au même niveau d'interconnexion que la ligne métallique 110 va également être contacté par un via électriquement conducteur simultanément au via venant contacter la portion de grille 134b. De manière analogue à la ligne métallique 110, la portion métallique 302 est recouverte par des portions des couches 113, 115, 138 et 139.

Pour cela, on réalise tout d'abord un masque de gravure 145 dont le motif (ouvertures 146 et 147 sur l'exemple de la figure 2P) correspond à celui des vias destinés à être réalisés.

On réalise ensuite une photolithographie et une gravure des portions des couches 115, 137, 138 et 139 à l'aplomb des ouvertures 146 et 147 du masque 145, formant des ouvertures 141 et 142 permettant respectivement un accès à une portion de la couche d'arrêt de gravure 135 recouvrant la portion de grille 134b et un accès à la couche 113 recouvrant la portion métallique 302 (figure 2Q). L'épaisseur de la couche d'arrêt de gravure 135 aura été choisie pour permettre de poursuivre la gravure des autres vias qui ont une profondeur différente. Dans le cas d'une gravure sèche d'oxyde, l'épaisseur de la couche d'arrêt de gravure 135 peut avoir une épaisseur par exemple comprise entre environ l'épaisseur d'oxyde restant à graver dans les autres vias et un douzième de cette épaisseur d'oxyde restant à graver dans les autres vias, et de préférence égale à environ un dixième de cette épaisseur d'oxyde restant à graver dans les autres vias.

La réalisation des vias et lignes métalliques supérieures est alors poursuivie conformément à la technologie « Dual Damascene » par exemple décrite dans le document « Silicon processing for the VLSI Era », vol. 4, pages 674-679.

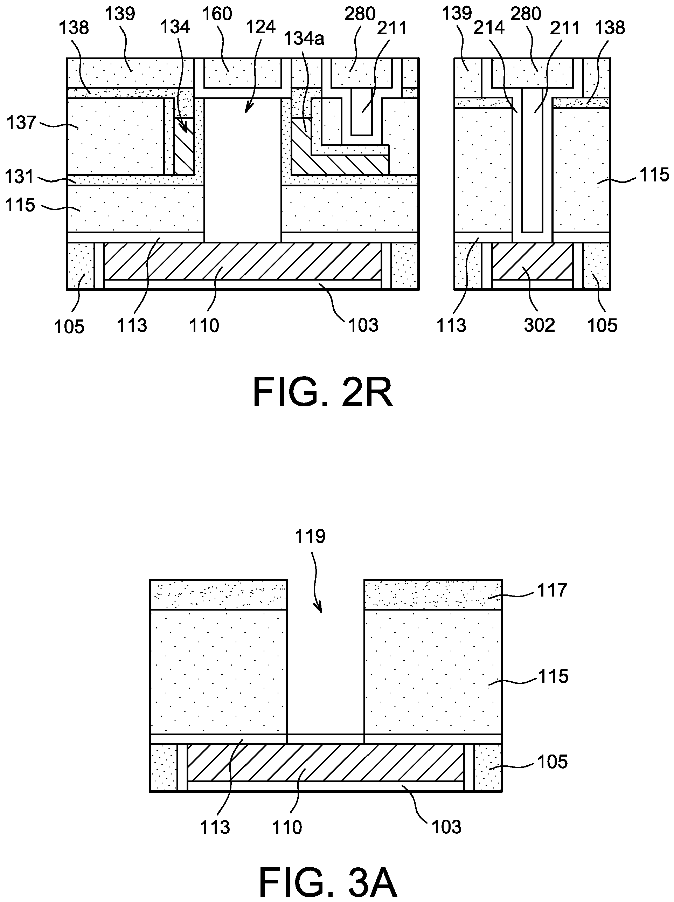

Ainsi, on grave tout d'abord les portions des couches 138 et 139 recouvrant le nanofil de semi-conducteur 124. Cette gravure peut permettre d'élargir les ouvertures 141 et 142 au niveau de la couche 139. On réalise ensuite le dépôt d'une couche barrière 214, par exemple à base de TiN dépôt par CVD ou à base de TaN/Ta ou de Ta seul recouvert d'une couche d'accroche à base de cuivre déposé par PVD (dépôt physique en phase vapeur), dans les ouvertures 141 et 142 ainsi que sur le nanofil 124 mis à nu. On réalise alors les vias métalliques 211, la ligne métallique 160 contactant le nanofil semi-conducteur 124, ainsi que d'autres portions 280 du niveau métallique supérieur contactant les vias métalliques 211, par exemple par électrodéposition de cuivre et CMP (figure 2R).

Toutes les lignes métalliques (référencées 160 et 280 sur la figure 2R) du niveau métallique supérieur sont donc réalisées simultanément par la mise en oeuvre d'étapes communes « Dual Damascene ».

Avantageusement, il est possible de réaliser, préalablement à l'étape de remplissage de cuivre, un siliciure à basse de température, par exemple à base de NiSi, au sommet du nanofil 124, permettant d'améliorer la qualité du contact électrique entre le nanofil 124 et la ligne métallique 210.

En variante de l'approche « Via First » précédemment décrite, il est possible de mettre en oeuvre une approche « Trench First » consistant à graver tout d'abord les portions des couches 138, 139 se trouvant au sommet du nanofil 124, puis à réaliser ensuite les ouvertures 141 et 142. Cette variante est ensuite achevée de manière analogue à l'approche « Via First ».

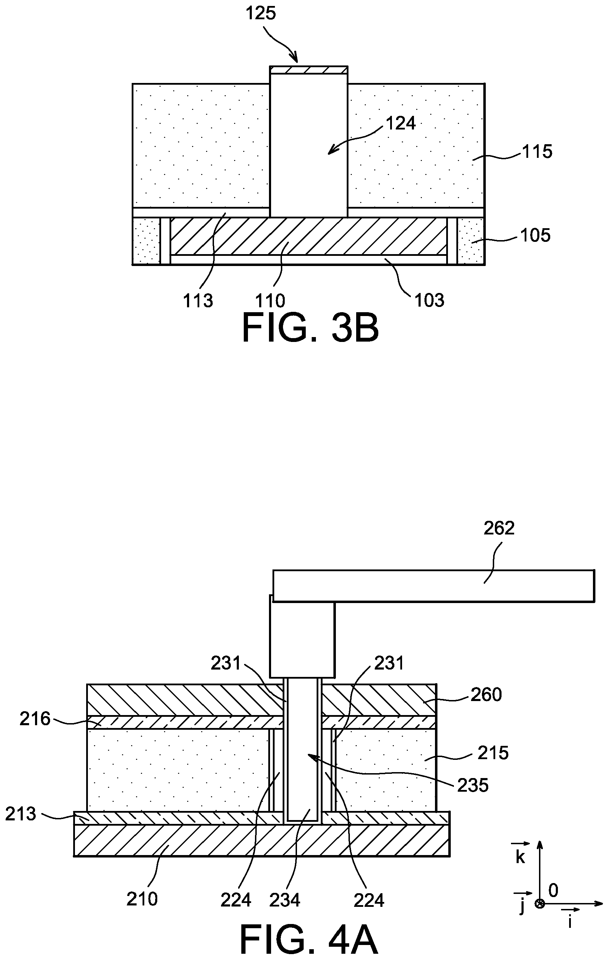

Une variante (figures 3A-3B) de l'exemple de procédé qui vient d'être décrit consiste à utiliser directement le métal de la ligne métallique 110 comme catalyseur de la croissance. Dans le cas où cette ligne métallique 110 est en cuivre ou en aluminium (figure 3A), la croissance de l'élément semi-conducteur 124 peut se faire directement sur cette ligne 110. Dans ce cas, une partie 125 du métal de la ligne métallique 110 servant à la croissance se retrouve, à l'issue de la croissance, au sommet de l'élément semi-conducteur 124 et permet de former un contact métallique (figure 3B).

Dans les exemples qui ont été décrits précédemment, on fait croitre l'élément semi-conducteur 124 formant un via, en utilisant une cavité dont cet élément 124 épouse la forme, puis on forme une électrode de grille autour de cet élément conducteur.

Un exemple de réalisation d'un dispositif microélectronique est illustré sur les figures 4A-4B.

Ce dispositif est formé sur un substrat (non représenté) sur lequel une pluralité de composants (non représentés) et de niveaux métalliques d'interconnexion des composants ont été réalisés.

La figure 4A représente une première ligne métallique horizontale 210 d'un niveau métallique donné Nₖ connectée par l'intermédiaire d'éléments de connexion verticaux 224, à une ligne métallique horizontale 260 d'un niveau métallique Nₘ supérieur (avec k < m ≤ p). Ces éléments de connexion 224 verticaux, peuvent être sous forme d'une pluralité de barreaux ou de nano-fils, et sont à base de matériau semi-conducteur, tel que par exemple du Si.

Les éléments 224 de connexion sont chacun entourés d'une zone à base de diélectrique 231 de grille, par exemple à base d'un diélectrique high-k.

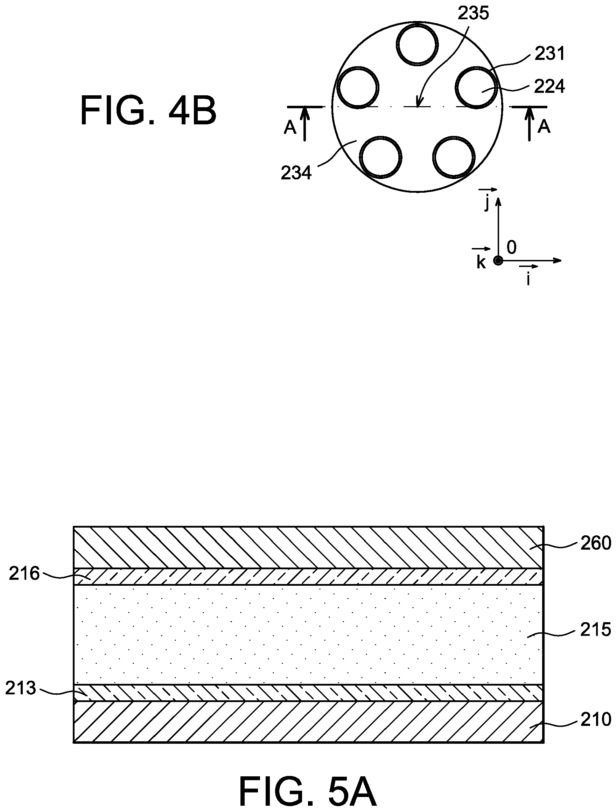

Une grille 234 permettant de contrôler la conduction des éléments 224 de connexion semi-conducteurs comporte une région 235 entourée par les éléments de connexion semi-conducteur 224 (sur la figure 4A, les éléments 224 de connexion verticaux sont représentés selon une vue en coupe dans le plan A-A représenté sur la figure 4B).

Les éléments 224 de connexion relient une première zone 213 disposée en contact le long de la ligne métallique horizontale 210 du niveau métallique donné Nₖ, et une deuxième zone 216 disposée en contact le long de la ligne métallique horizontale 260 du niveau métallique Nₘ supérieur.

Les zones 213, 216 peuvent être semi-conductrices et composées de silicium. Ces zones peuvent être déposées par PECVD (dépôt chimique en phase vapeur assisté par plasma). Ces zones pourront avantageusement être dopées in situ pendant le dépôt et/ou recristallisées partiellement ou totalement par la mise en oeuvre d'un procédé de recuit à une température inférieure ou égale à environ 425°C.

Les zones 213 et 216 peuvent jouer respectivement le rôle de zone de source et de zone de drain, ou inversement le rôle de zone de drain et de zone de source. Une couche diélectrique 215 disposée entre les lignes métalliques 210 et 260 de niveaux différents, sépare les zones de source et de drain 213 et 216.

La grille 234 est quant à elle polarisée par le biais d'une ligne métallique 262 d'un niveau métallique Nₙ, supérieur au niveau Nₘ.

Cette grille 234 permet, en fonction de la manière dont elle est polarisée, de contrôler la conduction des éléments 224 de connexion semi-conducteurs.

Selon une variante de réalisation, la première zone 213 en contact avec la première ligne métallique peut être métallique. La deuxième zone 216 en contact avec la deuxième ligne métallique peut être également métallique.

Afin de simplifier le positionnement et la définition du motif d'électrode de grille, on peut former cette électrode de grille, par remplissage dans une cavité dans laquelle est déjà disposé l'élément semi-conducteur 124.

Un exemple d'un tel procédé de réalisation va à présent être donné en liaison avec les figures 5A-5C.

Sur la figure 5A, le dispositif est montré en cours de réalisation.

Ce dispositif comprend un substrat (non représenté) sur lequel des composants ont été formés, par exemple des transistors ou des circuits logiques (non représentés), ainsi qu'au moins une ligne métallique 210 horizontale d'un niveau métallique d'interconnexion donné.

La ligne métallique 210 est recouverte d'un empilement formé d'une première zone 213 qui peut être semi-conductrice et par exemple à base de Si, et dans laquelle une zone de drain de transistor est destinée à être formée. La zone semi-conductrice 213 est elle-même recouverte d'une couche diélectrique 215, par exemple à base de SiO₂, elle-même recouverte d'une deuxième zone 216, qui peut être semi-conductrice et par exemple à base de Si, et dans laquelle une zone de source de transistor est destinée à être formée.

La deuxième zone 216 est elle-même recouverte d'une ligne métallique horizontale 260 d'un niveau métallique d'interconnexion supérieur audit niveau métallique d'interconnexion donné. La ligne métallique 260 peut être par exemple à base d'aluminium (figure 5A).

Ensuite, on forme une cavité 219 à travers la ligne métallique 260, la deuxième zone 216, la couche diélectrique 215, de manière à dévoiler la zone semi-conductrice 213.

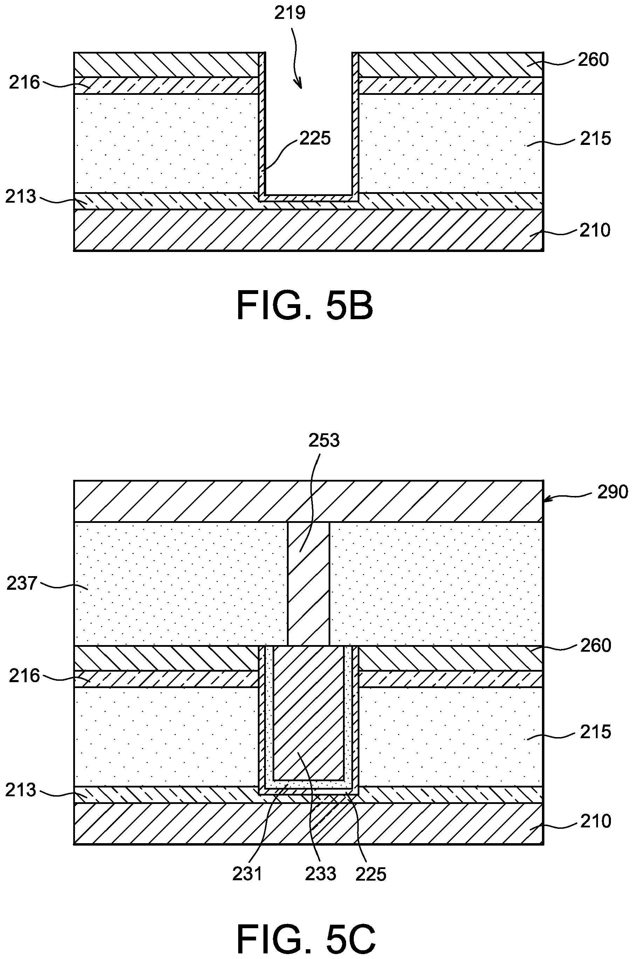

Dans cette cavité 219, on réalise ensuite un dépôt conforme d'une couche 225 d'un matériau semi-conducteur, par exemple du silicium, avantageusement dopé, ou un alliage silicium-germanium, ou du carbure de silicium (figure 5B). Ce semi-conducteur peut être monocristallin ou non, déposé par PVD ou CVD (dépôt chimique en phase vapeur) à une température inférieure ou égale à environ 400°C. Un dépôt de type CVD sera préféré afin d'obtenir une meilleure conformité de la couche 225.

Puis, on dépose successivement une couche de diélectrique 231 de grille, par exemple un diélectrique « high-k » et de matériau 233 de grille, par exemple formé d'un bicouche de TiN et de Cu ou de TiN et de W. Ces matériaux 231 et 233 viennent recouvrir la couche de semi-conducteur 225.

On effectue ensuite un retrait, par exemple par polissage des matériaux 231, 233 dépassant de l'embouchure de la cavité. Le retrait est réalisé avec arrêt sur la ligne métallique 260.

Ensuite, on forme une couche diélectrique 237, par exemple à base de SiO₂, dans laquelle on forme un plot conducteur 253, par exemple à base de tungstène en contact avec le matériau 233 de grille.

On forme ensuite une ligne métallique horizontale 290, par exemple à base de cuivre, sur la couche diélectrique 237 (figure 5C).

En variante (non représentée) de l'exemple qui vient d'être décrit, notamment dans le cas où la ligne métallique 260 est à base de cuivre, une zone métallique formant une barrière de diffusion peut être prévue autour de cette ligne 260 de cuivre. La zone barrière de diffusion peut être par exemple à base de TiN ou de TaN. Ainsi, les zones 213 et 216 peuvent être également chacune des zones métalliques, éventuellement à base d'un matériau métallique, tel que du Ti, ou un nitrure de titane, ou du TaN, servant de barrière de diffusion au métal des lignes métalliques 210 et 260.

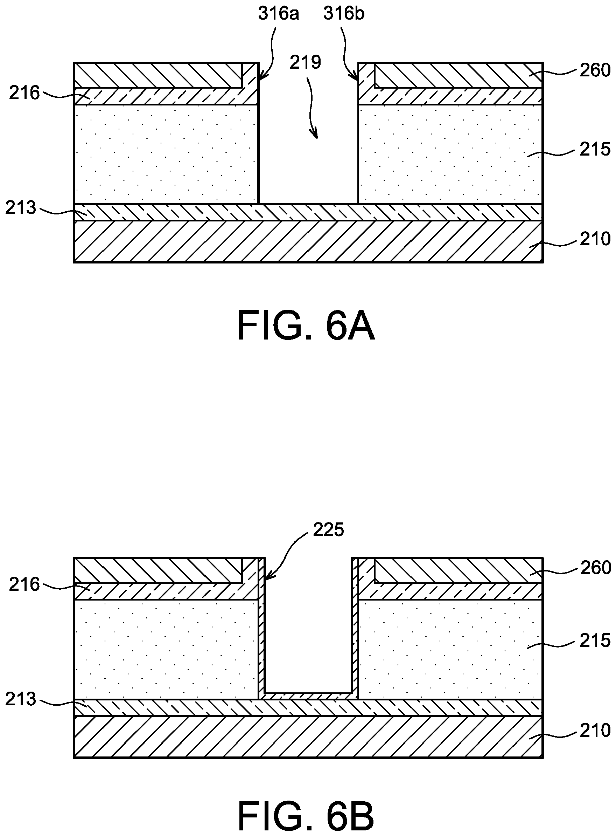

Une autre variante de réalisation est illustrée sur les figures 6A-6C.

Pour cette variante, la ligne métallique 260 du niveau supérieur est cette fois encapsulée dans le matériau de la deuxième zone 216 qui, de manière avantageuse, dans un matériau barrière de diffusion de métal.

Cette encapsulation peut être réalisée de sorte que des régions 316a, 316b de la deuxième zone 216 recouvrent des flancs de la ligne métallique supérieure 260 au niveau de la cavité 219.

Ces régions 316a, 316b sont obtenues lors de la formation de la ligne métallique 260. Le procédé mis en oeuvre consiste à réaliser un dépôt conforme d'une barrière à la diffusion suivi du remplissage de la ligne et d'un polissage. Le matériau de la deuxième zone 216 peut être prévu de sorte que cette dernière serve à la fois de barrière à la diffusion et de couche intermédiaire de contact électrique entre l'élément semi-conducteur 225 et la ligne métallique 260. Pour réaliser au mieux ces deux rôles, le matériau de la deuxième zone 216 peut être un métal, tel que du titane ou du tantale, ou un nitrure métallique tel que du nitrure de titane ou du nitrure de tantale.

La cavité 219 réalisée dans la couche diélectrique 215 dévoile les régions 316a, 316b (figure 6A) .

On réalise ensuite le dépôt de la couche de semi-conducteur 225 dans la cavité 219. Les zones 316a, 316b peuvent servir de barrière à une diffusion de métal (figure 6B).

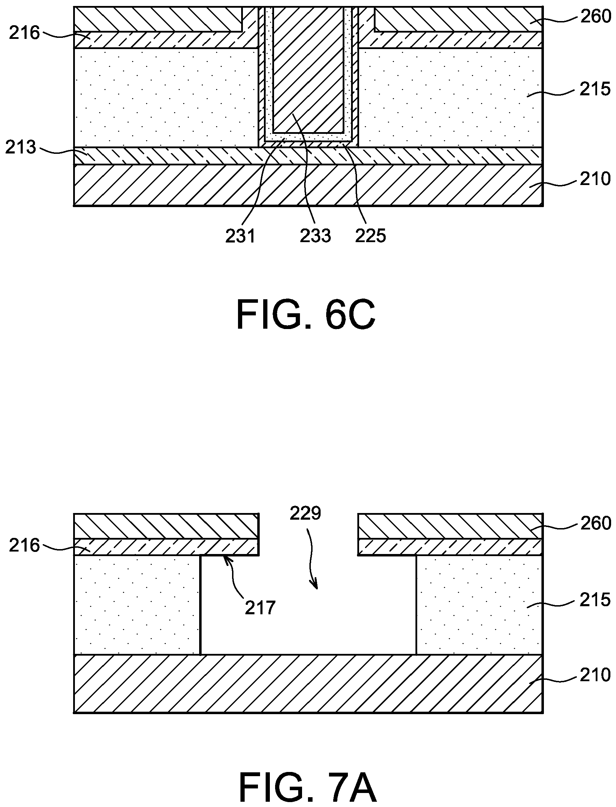

On effectue ensuite des étapes de dépôt de diélectrique 231 de grille puis de matériau 233 de grille dans la cavité de manière à former une électrode de grille entourée par la couche semi-conductrice 225 (figure 6C). Selon l'invention, l'élément d'interconnexion est réalisé en faisant croître plusieurs nano-fils semi-conducteurs 224 comme cela est illustré sur les figures 7A-7C.

Sur la figure 7A, le dispositif est montré en cours de réalisation. La ligne métallique 210 est recouverte d'une couche diélectrique 215, par exemple à base de SiO₂, elle-même recouverte de la deuxième zone 216 qui peut être semi-conductrice par exemple à base de Si.

La deuxième zone 216 est elle-même recouverte d'une deuxième ligne métallique horizontale 260 d'un niveau métallique d'interconnexion supérieur audit niveau métallique d'interconnexion donné.

Dans la couche diélectrique 215, on a pratiqué une cavité 229 dévoilant une face inférieure 217 de ladite deuxième zone 216 en contact avec ladite deuxième ligne métallique 260 (figure 7A).

Cette cavité 229 peut avoir été réalisée par gravure de ladite couche diélectrique 215 de manière à former une ouverture, puis élargir cette ouverture.

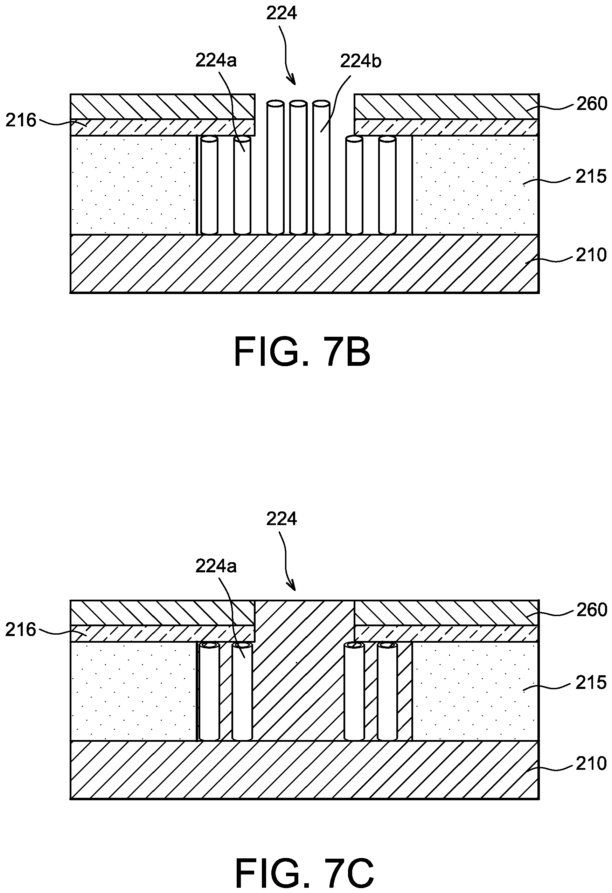

Ensuite, on forme les nano-fils semi-conducteurs 224 par croissance catalysée par le métal de la ligne 210 à partir de la ligne métallique 210. Cette croissance est réalisée de sorte que certains nano-fils 224a atteignent une région de la face inférieure 217 ou du dessous de ladite deuxième zone 216 (figure 7B).

Ensuite, on forme une grille par dépôt d'un diélectrique de grille et d'un matériau de grille dans la cavité 229, dans les espaces laissés libres entre les nano-fils 224. Certains nano-fils 224b, qui ont été formés au centre de la cavité 229 sans venir en contact avec la deuxième zone 216 peuvent avoir été préalablement retirés par une gravure anisotrope, par exemple à l'aide d'un plasma utilisant comme masque le matériau métallique de la deuxième ligne 260 (figure 7C).

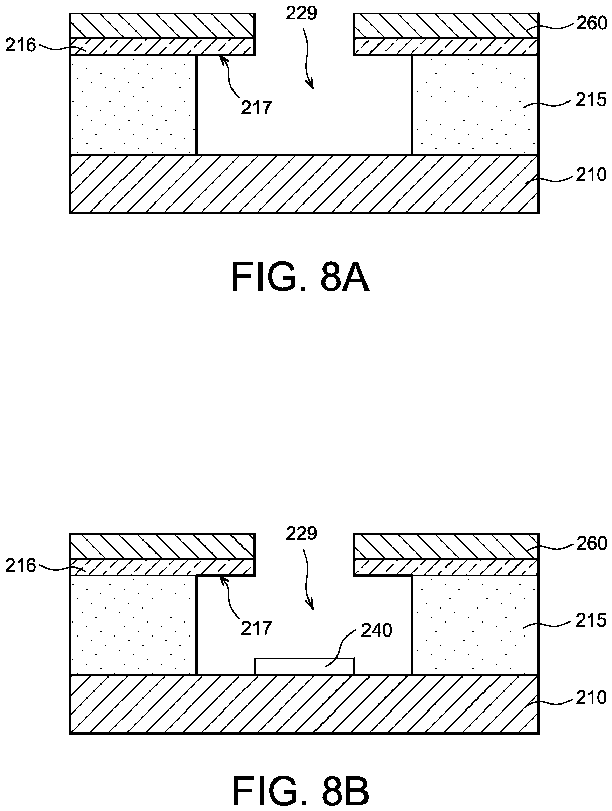

Un autre exemple de procédé de réalisation selon l'invention est illustré sur les figures 8A-8C.

Comme représenté sur la figure 8A, la structure initiale de cavité à partir de laquelle on réalise le procédé est similaire à celle représentée sur la figure 7A.

Comme représenté sur la figure 8B, on réalise ensuite un dépôt directionnel, par exemple par évaporation, d'un matériau 240 sur le catalyseur formé par la ligne métallique 210, ce matériau 240 formant un masque de croissance, empêchant ainsi la croissance ultérieure de nano-fils 224 sur les zones de la ligne métallique 210 recouvertes par le matériau 240. Le matériau 240 est choisi parmi des matériaux ne formant pas un catalyseur lors d'une croissance de nano-fils de semi-conducteur, et est par exemple à base de nitrure (nitrure de silicium, nitrure de titane, nitrure de tantale) ou d'oxyde non métallique (par exemple de l'oxyde de silicium).

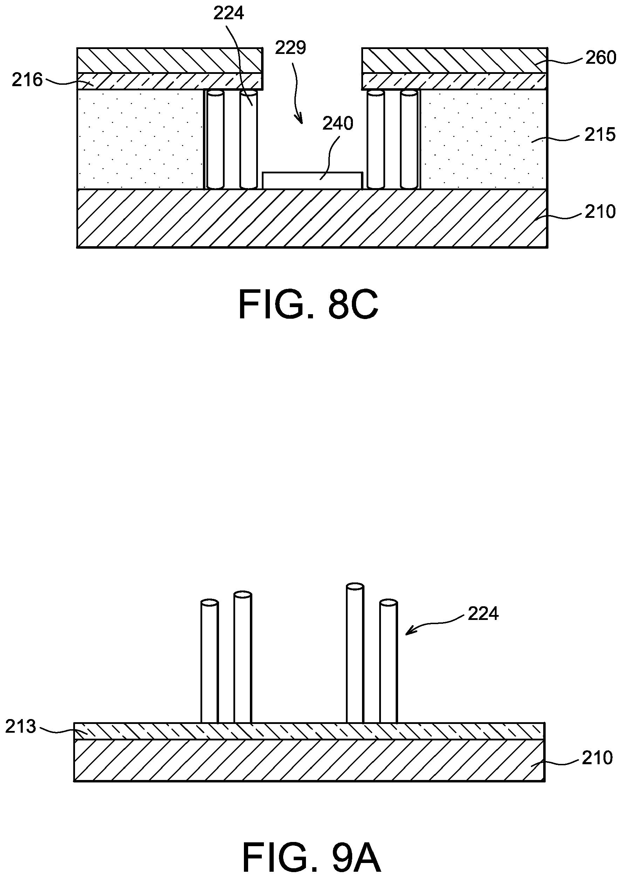

On réalise ensuite la croissance des nano-fils de semi-conducteur (figure 8C), formant des nano-fils 224 s'étendant entre la ligne métallique 210 et la face inférieure 217 de la deuxième zone 216. Suite à cette croissance, le matériau 240 peut être conservé ou non sur la ligne métallique 210. Il est par exemple possible, lorsque le matériau 240 est à base d'oxyde de silicium, de le supprimer par la mise en oeuvre d'une gravure sèche anisotrope utilisant la couche métallique supérieure 260 comme masque de gravure.

Puis, on forme une électrode de grille dans la cavité 229 notamment à l'aide d'étapes de dépôt d'une couche de diélectrique de grille et de matériau de grille.

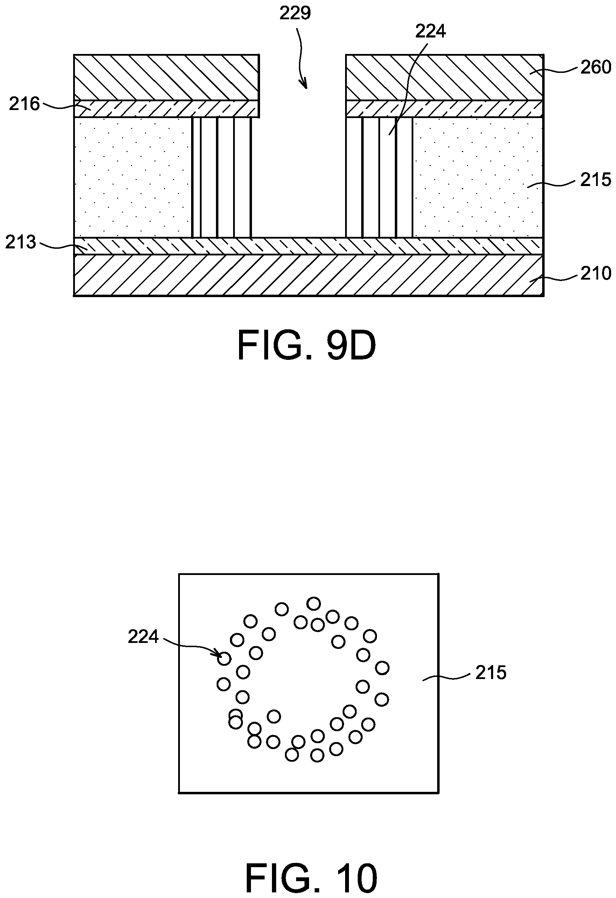

Un autre exemple de procédé de réalisation selon l'invention est illustré sur les figures 9A-9D et 10. Pour cette variante, l'élément semi-conducteur permettant la connexion entre des lignes métalliques, est également formé d'un ensemble de nano-fils. Cependant, cet ensemble de nano-fils est formé préalablement à une cavité dans laquelle on réalise la structure de grille permettant de contrôler la conduction de l'élément semi-conducteur.

Sur la figure 9A, le dispositif est montré en cours de réalisation.

La ligne métallique 210 est recouverte d'une première zone 213, qui peut être semi-conductrice.

On fait croitre tout d'abord des nano-fils semi-conducteurs 224 à partir de la zone semi-conductrice 213. Cette croissance peut être réalisée à l'aide d'un catalyseur.

On recouvre ensuite les nano-fils 224 d'une couche diélectrique 215, par exemple à base de SiO₂.

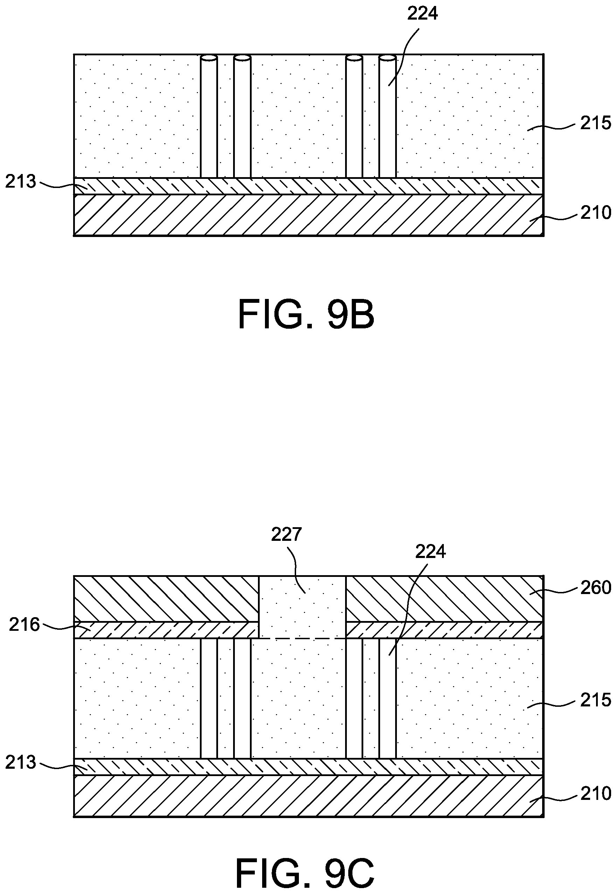

Une étape de polissage de la couche diélectrique 215 est ensuite réalisée, de manière à dévoiler l'extrémité libre des nano-fils 224. Cette étape peut permettre de retirer une portion de certains des nanofils 224 de manière à obtenir un ensemble de nanofils 224 de hauteurs respectives sensiblement égales (figures 9B et 10, la figure 10 représentant les nanofils encapsulés en vue de dessus).

On forme ensuite la deuxième zone 216 et la deuxième ligne métallique horizontale 260 d'un niveau métallique d'interconnexion supérieur au niveau métallique de la ligne métallique 210. La deuxième zone 216 peut être semi-conductrice ou métallique et formée en contact avec l'extrémité libre des nano-fils 224.

Une ouverture à travers la ligne métallique 260 et dans la deuxième zone 216 peut être formée, puis remplie de matériau diélectrique 227. Une étape de polissage du matériau diélectrique 227 peut être ensuite réalisée, de manière à retirer ce dernier du dessus de la ligne métallique 260 (figure 9C).

Ensuite, on réalise une cavité 229 par gravure de la couche diélectrique 215 et du matériau diélectrique 227, de manière à dévoiler les nanofils 224 et la première zone 213 à partir de laquelle on a réalisé leur croissance (figure 9D).

Ensuite, on forme une grille par dépôt d'un diélectrique de grille et d'un matériau de grille dans la cavité 229.

Dans le cas où la ligne métallique 260 du niveau supérieur est à base de cuivre, une barrière de diffusion peut être prévue.

Dans les exemples précédemment décrits, les zones 213 et 216, qui sont optionnelles, peuvent être semi-conductrices et être éventuellement dopées. Les zones 213 et 216 peuvent être réalisées à base de Si déposé et éventuellement dopé.

Les zones 213, 216 présentes contre les lignes métalliques 210 et 260 peuvent être prévues afin d'améliorer le contact électrique entre le métal et le semi-conducteur.

Ces zones 213 et 216 peuvent être formées d'un métal, comme par exemple de l'aluminium, du chrome ou du tantale, présentant une faible différence entre le travail de sortie de ce métal et l'affinité électronique de l'élément semi-conducteur 224,.

## Revendications

1. Procédé de réalisation d'un dispositif microélectronique doté d'au moins un élément de connexion entre une première ligne métallique d'un niveau métallique d'interconnexion donné et une deuxième ligne métallique d'un autre niveau métallique d'interconnexion, l'élément de connexion étant semi-conducteur et doté de nano-fils et d'une électrode de grille prévue pour contrôler la conduction des nano-fils, le procédé comprenant des étapes de :
a) réalisation, sur une première ligne métallique (110, 210) d'un niveau métallique d'interconnexion donné, d'au moins un élément de connexion semi-conducteur (124, 224) formé d'une pluralité de nano-fils (224) obtenus par une croissance directement sur la première ligne métallique (110, 210) et disposés dans une cavité (119, 229) formée à travers une couche diélectrique (215) reposant sur la première ligne métallique (110, 210) , ledit élément de connexion semi-conducteur (124, 224) étant destiné à connecter la première ligne métallique (110, 210) à une deuxième ligne métallique (160, 260) d'un autre niveau métallique d'interconnexion situé au-dessus dudit niveau métallique d'interconnexion donné et tel que les nano-fils semi-conducteurs (124, 224) s'étendent dans une direction réalisant un angle non-nul avec lesdites première ligne métallique (110, 210) et deuxième ligne métallique (160, 260), puis
b) formation dans ladite cavité (119, 229) d'une électrode de grille (134, 234) pour contrôler la conduction des nano-fils (124, 224) par dépôt d'un diélectrique de grille puis d'un matériau de grille (134, 234) dans la cavité (119, 229), de manière à remplir des espaces libres entre les nano-fils (224), de sorte que les nanofils (224) sont entourés par une zone du diélectrique de grille et une zone de matériau de grille (134, 234), et qu'au moins une région de l'électrode de grille (134, 234) est entourée par les nano-fils (224).

2. Procédé selon la revendication 1, dans lequel une croissance de l'élément semi-conducteur (124) est effectuée à l'aide d'un catalyseur (121) déposé sur la première ligne métallique (110).

3. Procédé selon la revendication 2, dans lequel la cavité (119) comportant des flancs latéraux (120) et un fond, le fond dévoilant la première ligne métallique (110), la croissance de l'élément semi-conducteur (124) étant effectuée à l'aide d'un bloc (121b) de catalyseur formé par dépôt sélectif sans recouvrir les flancs (120) de la cavité (119).

4. Procédé selon la revendication 1, dans lequel la croissance de l'élément semi-conducteur (124) est effectuée en se servant du matériau métallique de la première ligne métallique (110) comme catalyseur.

5. Procédé selon l'une des revendications 1 à 4, comprenant, préalablement à l'étape b), des étapes consistant à :
- faire croître les nano-fils (224), puis
- former ladite couche diélectrique (215), de manière à entourer les nano-fils (224), puis
- former ladite cavité (229) par gravure de ladite couche diélectrique (215) autour des nano-fils (224) et de manière à dévoiler ces derniers.

6. Procédé selon l'une des revendications 1 à 4, comprenant, préalablement à l'étape b), des étapes consistant à :
- former ladite couche diélectrique (215) et ladite cavité (229) dans cette couche diélectrique (215), puis
- faire croître les nano-fils (224) dans ladite cavité (224), puis
- former la grille (234) dans ladite cavité (229).

## Patentansprüche

1. Verfahren zum Herstellen einer mikroelektronischen Vorrichtung, die mit zumindest einem Verbindungselement zwischen einer ersten Metallleitung auf gegebener Metallverbindungsebene und einer zweiten Metallleitung auf einer anderen Metallverbindungsebene versehen ist, wobei das Verbindungselement ein Halbleiter ist und mit Nanodrähten und einer Gate-Elektrode versehen ist, die dazu vorgesehen ist, die Leitfähigkeit der Nanodrähte zu kontrollieren, wobei das Verfahren die nachfolgenden Schritte umfasst:
a) Ausbilden von zumindest einem Halbleiterverbindungselement (124, 224) an einer ersten Metallleitung (110, 210) auf gegebener Metallverbindungsebene, das aus einer Mehrzahl von Nanodrähten (224) gebildet ist, die durch Aufwachsen direkt an der ersten Metallleitung (110, 210) erhalten werden und in einer Vertiefung (119, 229) angeordnet sind, die durch eine dielektrische Schicht (215) hindurch ausgebildet ist, die an der ersten Metallleitung (110, 210) aufliegt, wobei das Halbleiterverbindungselement (124, 224) dazu bestimmt ist, die erste Metallleitung (110, 210) mit einer zweiten Metallleitung (160, 260) auf einer anderen Metallverbindungsebene zu verbinden, die über der gegebenen Metallverbindungsebene liegt, so dass die Halbleiternanodrähte (124, 224) sich in einer Richtung erstrecken, die einen Winkel ungleich null mit der ersten Metallleitung (110, 210) und der zweiten Metallleitung (160, 260) einschließt, dann
b) Ausbilden einer Gate-Elektrode (134, 234) in der Vertiefung (119, 229), um die Leitfähigkeit der Nanodrähte (124, 224) durch Abscheiden eines Gate-Dielektrikums und dann eines Gate-Materials (134, 234) in der Vertiefung (119, 229) zu kontrollieren, so dass die Freiräume zwischen den Nanodrähten (224) verfüllt werden, so dass die Nanodrähte (224) von einem Bereich des Gate-Dielektrikums und einem Bereich des Gate-Materials (134, 234) umgeben werden und dass zumindest ein Bereich der Gate-Elektrode (134, 234) von den Nanodrähten (224) umgeben wird.

2. Verfahren nach Anspruch 1, wobei ein Aufwachsen des Halbleiterelements (124) mit Hilfe eines Katalysators (121) erfolgt, der auf die erste Metallleitung (110) abgeschieden ist.

3. Verfahren nach Anspruch 2, wobei die Vertiefung (119) Seitenflanken (120) und einen Boden enthält, wobei der Boden die erste Metallleitung (110) freilegt, wobei das Aufwachsen des Haltleiterelements (124) mit Hilfe eines Katalysatorblocks (121b) erfolgt, der durch selektives Abschneiden ausgebildet wird, ohne dabei die Flanken (120) der Vertiefung (119) zu überdecken.

4. Verfahren nach Anspruch 1, wobei das Aufwachsen Halbleiterelements (124) erfolgt, indem das metallische Material der ersten Metallleitung (110) als Katalysator dient.

5. Verfahren nach einem der Ansprüche 1 bis 4, das vor dem Schritt b) die nachfolgenden Schritte umfasst:
- Züchten der Nanodrähte (224), dann
- Ausbilden der dielektrischen Schicht (215), so dass sie die Nanodrähte (224) umgibt, dann
- Ausbilden der Vertiefung (229) durch Ätzen der dielektrischen Schicht (215) um die Nanodrähte (224) herum, so dass letztere freigelegt werden.

6. Verfahren nach einem der Ansprüche 1 bis 4, das vor dem Schritt b) nachfolgende Schritte umfasst:
- Ausbilden der dielektrischen Schicht (215) und der Vertiefung (229) in dieser dielektrischen Schicht (215), dann
- Züchten der Nanodrähte (224) in der Vertiefung (229), dann
- Ausbilden des Gates (234) in der Vertiefung (229).

## Claims

1. A Method for producing a microelectronic device comprising at least a connection element between a first metal line of a given metallic interconnecting level and a second metal line of another metallic interconnecting level, the connection element being semiconductor and comprising nano-wires and a gate electrode for controlling the conduction of the nanowires, the method comprising the steps of:
a) forming, on a first metal line of a given metal interconnection level, at least one semiconductor connection element (124, 224) formed of a plurality of nano-wires obtained by growing the nano-wires directly on the first metal line (110, 210) and arranged in a cavity (119, 229) formed through a dielectric layer resting on the first metal line (110, 210) said semiconductor connection element being intended to connect the first metal line (110, 210) to a second metal line (160, 260) of another metal interconnection line located above said given metal interconnection line and such that the nano-wires extend in a direction forming a nonzero angle with said first metal line and second metal line, then
b) formation in said cavity (119, 219) of a gate electrode (134, 234) to control the conduction of the nano-wires (124, 224) by depositing a gate dielectric then and gate material (134, 234) in said cavity (119, 229), so as to fill the spaces between the nano-wires (224), so that the nano-wires are surrounded by a dielectric zone (134, 234) and at least a gate electrode region (134, 234) is surrounded by the nano-wires (224).

2. Method according to claim 1, wherein growth of the semiconductor element (124) is carried out by means of a catalyst (121) deposited on the first metal line (110).

3. A Method according to claim 2, wherein the cavity (119) comprises lateral sides and a bottom, the bottom exposing the first metal line (110), the growth of the semiconductor element (124) being carried out by means of a block (121b) of catalyst formed by selective deposition without covering the sides (120) of the cavity (119).

4. A Method according to claim 1, wherein the growth of the semiconductor element (124) is carried out making use of the metal material of the first metal line (110) as catalyst.

5. A Method according to any of the claims 1 to 4, comprising, prior to step b), the steps consisting in:
- growing the nano-wires (224), then
- forming said dielectric layer (215), so as to surround the nano-wires (224),
- forming said cavity (229) by etching of said dielectric layer (215) around the nano-wires (224) and so as to expose the latter.

6. A Method according to any of the claims 1 to 4, comprising, prior to step b), steps consisting in:
- forming said dielectric layer (215) and said cavity (229) in said dielectric layer (215),
- then growing the nano-wires (224) in said cavity (229),
- forming the gate (234) in said cavity (229).
